# EUROPEAN PATENT SPECIFICATION

(11) **EP 4 350 776 B1**
(45) Date of publication and mention of the grant of the patent: **08.10.2025**
(21) Application number: 22922082.7
(22) Date of filing: 28.11.2022
(51) Int. Cl.: H01L 21/265, H01L 21/28, H01L 21/76, H10D 12/00, H10D 62/10, H10D 62/17, H10D 62/832, H10D 64/00, H10D 64/27, H10D 84/00, H10D 84/01, H10D 84/03

(54) **SEMICONDUCTOR DEVICE**
HALBLEITERANORDNUNG
DISPOSITIF À SEMI-CONDUCTEUR

(30) Priority: 20.01.2022 JP 2022007007
(43) Date of publication of application: 10.04.2024
(73) Proprietor: Fuji Electric Co., Ltd., Kawasaki-shi, Kanagawa 210-9530 (JP)
(72) Inventor: NOGUCHI, Seiji, Kawasaki-shi, Kanagawa 210-9530 (JP); SAKURAI, Yosuke, Kawasaki-shi, Kanagawa 210-9530 (JP); IKURA, Yoshihiro, Kawasaki-shi, Kanagawa 210-9530 (JP); HAMASAKI, Ryutaro, Kawasaki-shi, Kanagawa 210-9530 (JP); OZAKI, Daisuke, Kawasaki-shi, Kanagawa 210-9530 (JP)
(74) Representative: MERH-IP Matias Erny Reichl Hoffmann Patentanwälte PartG mbB
(86) International application number: PCT/JP2022/043770
(87) International publication number: WO 2023/139931

(56) References cited:
- WO-A1-2015/166754
- JP-A- 2016 189 368
- JP-A- 2019 091 892
- JP-A- 2019 110 288
- JP-A- 2019 169 575
- JP-A- 2019 212 718
- US-A1- 2014 027 840
- US-A1- 2017 243 746

## Description

### BACKGROUND

### 1. TECHNICAL FIELD

The present invention relates to a semiconductor device.

### 2. RELATED ART

Conventionally, in a semiconductor device such as an Insulated Gate Bipolar Transistor (IGBT) or the like, there is known a configuration in which an impurity region is provided at a bottom of a trench portion (see Patent Documents 1 and 2, for example).
Patent document 3 relates to various improvements in vertical transistors, such as IGBTs. These improvements include forming periodic, highly doped p-type emitter dots in the top surface region of a growth substrate, followed by growing the transistor layers and grinding down the bottom surface of the substrate. This is followed by a wet etch of the bottom surface to expose the heavily doped p+ layer, over which a metal contact is then formed. Patent document 3 discloses an IGBT device provided with an active region surrounded by an edge termination region. The device is further provided with a plurality of trenches disposed at different intervals. The device is also provided with buried field rings disposed at bottoms of each of the plurality of the trenches. The buried field ring that is disposed at an outer boundary of a device is in a direct contact with a well having the same conductivity type as the buried field ring.
Patent document 4 describes a termination structure for a high-voltage semiconductor transistor device. This structure consists of at least two termination zones and an electrical disconnection between the body layer and the device edge. The first zone is designed to spread the electric field within the device, while the second zone smoothly brings the electric field back to the top surface. The electrical disconnection prevents the device from short-circuiting at the edge.

### PRIOR ART DOCUMENT

### PATENT DOCUMENT

Patent Document 1: Japanese Patent Application Publication No. 2019-91892
Patent Document 2: Japanese Patent Application Publication No. 2019-110288
Patent Document 3: US 2017/0243746 A1
Patent Document 4: US 2014/0027840 A1

### TECHNICAL PROBLEM

It is preferable to reduce a breakdown voltage imbalance in a semiconductor device such as an IGBT device.

### GENERAL DISCLOSURE

The present invention is defined by the appended claims. In order to solve the above problem, a first aspect of the present invention provides a semiconductor device as defined in claim 1. Further embodiments are defined in dependent claims 2 - 10.

### BRIEF DESCRIPTION OF THE DRAWINGS

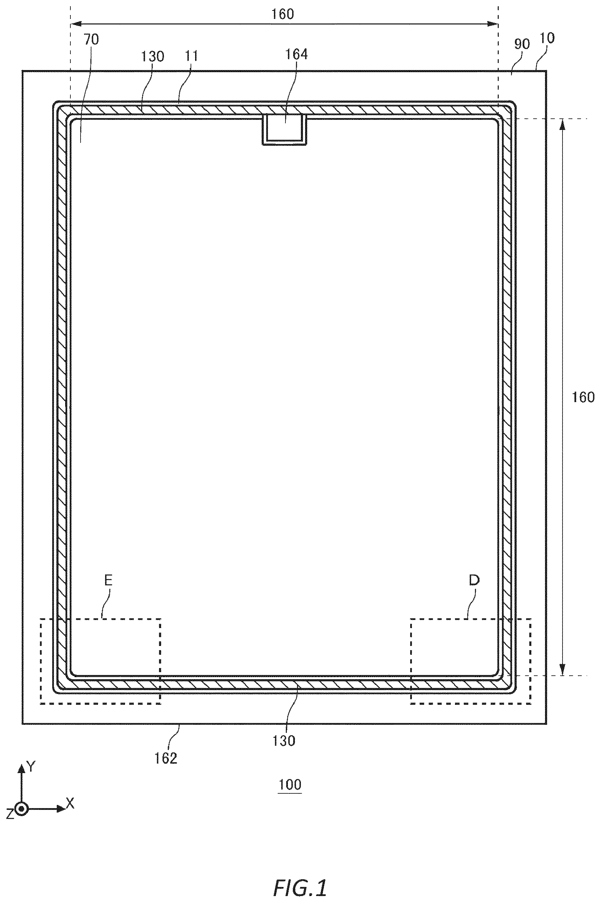

[0018] FIG. 1 is a top view showing an example of a semiconductor device 100 according to an exemplary embodiment.
Fig. 2 is an enlarged view of a region D in Fig. 1.
Fig. 3 illustrates an example of a cross section e-e in Fig. 2.
FIG. 4 illustrates an example of a cross section f-f in FIG. 2.
FIG. 5 illustrates an example of a cross section g-g in FIG. 2.
FIG. 6 illustrates an example of a method for manufacturing the semiconductor device 100. The method is not claimed but it is useful for understanding the present invention.
FIG. 7 illustrates an example of a method for manufacturing the semiconductor device 100. The method is not claimed but it is useful for understanding the present invention.
FIG. 8 illustrates an example of arrangement of a resist 208 provided in a resist formation step S302.
FIG. 9 illustrates an example of arrangement of the resist 208 provided in the resist formation step S302.
Fig. 10 illustrates another example of the cross section e-e in Fig. 2.
FIG. 11 illustrates another example of the cross section e-e in FIG. 2.
FIG. 12 illustrates another example of the cross section e-e in FIG. 2.
FIG. 13 illustrates another example of the cross section e-e in FIG. 2.
FIG. 14 is a top view showing an example of a semiconductor device 200 according to another exemplary embodiment.
FIG. 15 is a top view showing an example of a semiconductor device 300 according to another exemplary embodiment.
FIG. 16 illustrates an example of a semiconductor device 400 according to a comparative example not forming part of the present invention but being useful for its understanding.
FIG. 17 illustrates an example of a semiconductor device 500 according to a comparative example not forming part of the present invention but being useful for its understanding.
FIG. 18 illustrates an example of a semiconductor device 600 according to a comparative example not forming part of the present invention but being useful for its understanding.
FIG. 19 illustrates relationships between a forward current and a slope of a reverse recovery voltage, of an FWD at room temperature.
FIG. 20 illustrates relationships between a maximum value of a slope of a reverse recovery voltage of an FWD (at room temperature and low current) and a turn-on loss (at high temperature and rated current).
FIG. 21 illustrates I-V characteristics between a collector current and a collector voltage when a gate voltage is 0 V (OFF) for the semiconductor device 100 and the semiconductor device 500.
FIG. 22 illustrates I-V characteristics between a collector current and a collector voltage when a gate voltage is 15 V (ON) for the semiconductor device 100 and the semiconductor device 600.
FIG. 23 illustrates I-V characteristics between a collector current and a collector voltage for the semiconductor device 500 and the semiconductor device 600.

### DESCRIPTION OF EXEMPLARY EMBODIMENTS

In the present specification, one side in a direction parallel to a depth direction of a semiconductor substrate is referred to as "upper" and the other side is referred to as "lower". One surface of two principal surfaces of a substrate, a layer or other members is referred to as an upper surface, and the other surface is referred to as a lower surface. The "upper" and "lower" directions are not limited to a gravity direction or a direction when a semiconductor device is mounted.

In the present specification, technical matters may be described using orthogonal coordinate axes of an X axis, a Y axis, and a Z axis. The orthogonal coordinate axes are merely for specifying relative positions of components, and not for limiting a specific direction. For example, the Z axis is not limited to indicating a height direction with respect to the ground. It should be noted that a +Z axis direction and a -Z axis direction are directions opposite to each other. When a Z axis direction is described without describing a positive or negative sign, it means that the direction is parallel to the +Z axis and the -Z axis.

In the present specification, orthogonal axes parallel to the upper surface and the lower surface of the semiconductor substrate are referred to as the X axis and the Y axis. In addition, an axis perpendicular to the upper surface and the lower surface of the semiconductor substrate is referred to as the Z axis. In the present specification, the direction of the Z axis may be referred to as the depth direction. In addition, in the present specification, a direction parallel to the upper surface and the lower surface of the semiconductor substrate may be referred to as a horizontal direction, including an X axis direction and a Y axis direction.

In addition, a region from a center of the semiconductor substrate in the depth direction to the upper surface of the semiconductor substrate may be referred to as an upper surface side. Similarly, a region from the center of the semiconductor substrate in the depth direction to the lower surface of the semiconductor substrate may be referred to as a lower surface side.

In the present specification, a case where a term such as "same" or "equal" is mentioned may include a case where an error due to a variation in manufacturing or the like is included. The error is, for example, within 10%.

In the present specification, a conductivity type of a doping region in which doping has been carried out with an impurity is described as a P type or an N type. In the present specification, the impurity may particularly mean either a donor of the N type or an acceptor of the P type, and may be described as a dopant. In the present specification, doping means introducing the donor or the acceptor into the semiconductor substrate and turning it into a semiconductor presenting a conductivity type of the N type or a semiconductor presenting a conductivity type of the P type.

In the present specification, a doping concentration means a concentration of the donor or a concentration of the acceptor in a thermal equilibrium state. In the present specification, a net doping concentration means a net concentration obtained by adding the donor concentration set as a positive ion concentration to the acceptor concentration set as a negative ion concentration, taking into account of polarities of charges. As an example, when the donor concentration is N_{D} and the acceptor concentration is N_{A}, the net doping concentration at any position is given as N_{D} - N_{A}. In the present specification, the net doping concentration may be simply described as the doping concentration.

The donor has a function of supplying electrons to a semiconductor. The acceptor has a function of receiving electrons from the semiconductor. The donor and the acceptor are not limited to the impurities themselves. For example, a VOH defect in which a vacancy (V), oxygen (O), and hydrogen (H) present in the semiconductor are attached together functions as the donor that supplies electrons. In the present specification, the VOH defect may be referred to as a hydrogen donor.

In the present specification, a description of a P+ type or an N+ type means a higher doping concentration than that of the P type or the N type, and a description of a P- type or an N- type means a lower doping concentration than that of the P type or the N type. In addition, in the present specification, a description of a P++ type or an N++ type means a higher doping concentration than that of the P+ type or the N+ type. In the present specification, a unit system is the SI base unit system unless otherwise noted. Although a unit of length is represented using cm, it may be converted to meters (m) before calculations.

A chemical concentration in the present specification refers to an atomic density of an impurity measured regardless of an electrical activation state. The chemical concentration (atomic density) can be measured by, for example, secondary ion mass spectrometry (SIMS). The net doping concentration described above can be measured by voltage-capacitance profiling (CV profiling). In addition, a carrier concentration measured by spreading resistance profiling (SRP method) may be set as the net doping concentration. The carrier concentration measured by the CV profiling or the SRP method may be a value in a thermal equilibrium state. In addition, in a region of the N type, the donor concentration is sufficiently higher than the acceptor concentration, and thus the carrier concentration of the region may be set as the donor concentration. Similarly, in a region of the P type, the carrier concentration of the region may be set as the acceptor concentration. In the present specification, the doping concentration of the N type region may be referred to as the donor concentration, and the doping concentration of the P type region may be referred to as the acceptor concentration.

In addition, when a concentration distribution of the donor, acceptor, or net doping has a peak in a region, a value of the peak may be set as the concentration of the donor, acceptor, or net doping in the region. In a case where the concentration of the donor, acceptor or net doping is substantially uniform in a region, or the like, an average value of the concentration of the donor, acceptor or net doping in the region may be set as the concentration of the donor, acceptor or net doping. In the present specification, atoms/cm³ or /cm³ is used to indicate a concentration per unit volume. This unit is used for a concentration of a donor or an acceptor in a semiconductor substrate, or a chemical concentration. A notation of atoms may be omitted.

The carrier concentration measured by the SRP method may be lower than the concentration of the donor or the acceptor. In a range where a current flows when a spreading resistance is measured, carrier mobility of the semiconductor substrate may be lower than a value in a crystalline state. The decrease in carrier mobility occurs when carriers are scattered due to disorder (disorder) of a crystal structure due to a lattice defect or the like.

The concentration of the donor or the acceptor calculated from the carrier concentration measured by the CV profiling or the SRP method may be lower than a chemical concentration of an element indicating the donor or the acceptor. As an example, in a silicon semiconductor, a donor concentration of phosphorus or arsenic serving as a donor, or an acceptor concentration of boron (boron) serving as an acceptor is approximately 99% of chemical concentrations of these. On the other hand, in the silicon semiconductor, a donor concentration of hydrogen serving as a donor is approximately 0.1% to 10% of a chemical concentration of hydrogen. Each concentration in the present specification may be a value at room temperature. As an example, a value at 300K (Kelvin) (about 26.9 degrees C) may be used for the value at the room temperature.

FIG. 1 is a top view showing an example of a semiconductor device 100 according to an exemplary embodiment. Fig. 1 shows a position of each member projected onto an upper surface of a semiconductor substrate 10. In Fig. 1, only some members of the semiconductor device 100 are shown, and illustrations of some members are omitted.

The semiconductor device 100 includes the semiconductor substrate 10. The semiconductor substrate 10 is a substrate formed of a semiconductor material. The semiconductor substrate 10 is a silicon substrate, as an example, but a material of the semiconductor substrate 10 is not limited to silicon.

The semiconductor substrate 10 includes an end side 162 in a top view. When simply referred to as the top view in the present specification, it means that the semiconductor substrate 10 is viewed from an upper surface side. The semiconductor substrate 10 in the present example includes two sets of end sides 162 facing each other in a top view. In Fig. 1, the X axis and the Y axis are parallel to any of the end sides 162. In addition, the Z axis is perpendicular to the upper surface of the semiconductor substrate 10.

The semiconductor substrate 10 is provided with an active portion 160. The active portion 160 is a region in which a main current flows in the depth direction between the upper surface and a lower surface of the semiconductor substrate 10 when the semiconductor device 100 operates. An emitter electrode is provided above the active portion 160, but illustration thereof is omitted in Fig. 1.

In the present example, the active portion 160 is provided with a transistor portion 70 including a transistor element such as an IGBT. In another example, transistor portions 70 and diode portions including diode elements such as a Free Wheel Diode (FWD) may be alternately arranged along a predetermined array direction at the upper surface of the semiconductor substrate 10. In the present specification, an array direction is the X axis direction.

The transistor portion 70 includes a collector region of the P+ type in a region in contact with the lower surface of the semiconductor substrate 10. In addition, in the transistor portion 70, gate structures having emitter regions of the N++ type, base regions of the P- type, gate conductive portions, and gate dielectric films are periodically arranged on the upper surface side of the semiconductor substrate 10.

The semiconductor device 100 may include one or more pads above the semiconductor substrate 10. The semiconductor device 100 in the present example includes a gate pad 164. The semiconductor device 100 may include pads such as an anode pad, a cathode pad, and a current detection pad. Each pad is arranged in the vicinity of the end side 162. The vicinity of the end side 162 refers to a region between the end side 162 in a top view and the emitter electrode. When the semiconductor device 100 is mounted, each pad may be connected to an external circuit via a wiring line such as a wire.

A gate potential is applied to the gate pad 164. The gate pad 164 is electrically connected to a conductive portion of the gate trench portion of the active portion 160. The semiconductor device 100 includes a gate runner 130 that connects the gate pad 164 and the gate trench portion. In FIG. 1, the gate runner 130 is hatched with diagonal lines.

The gate runner 130 is arranged between the active portion 160 and the end side 162 of the semiconductor substrate 10 in a top view. The gate runner 130 in the present example encloses the active portion 160 in a top view. A region enclosed by the gate runner 130 in a top view may be the active portion 160. In addition, the gate runner 130 is connected to the gate pad 164. The gate runner 130 is arranged above the semiconductor substrate 10. The gate runner 130 may be a metal wiring line containing aluminum or the like.

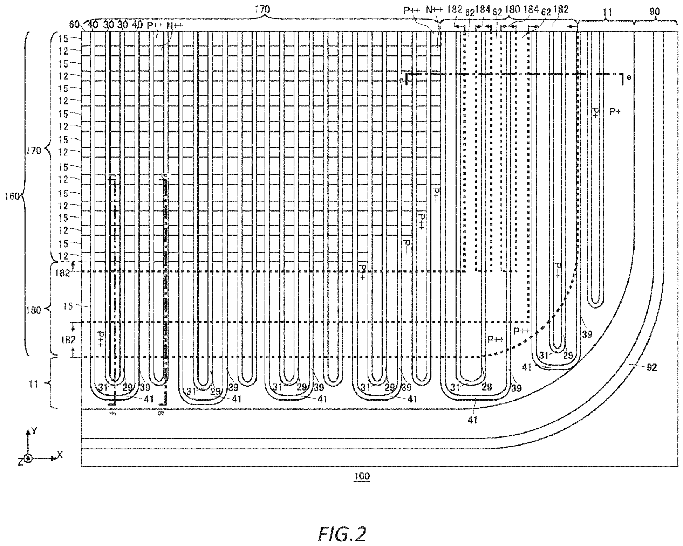

An outer circumferential well region 11 is provided to overlap the gate runner 130. That is, similarly to the gate runner 130, the outer circumferential well region 11 encloses the active portion 160 in a top view. The outer circumferential well region 11 is also provided extending with a predetermined width in a range which does not overlap the gate runner 130. The outer circumferential well region 11 is a region of a second conductivity type. The outer circumferential well region 11 in the present example is of the P+ type (see FIG. 2). An impurity concentration of the outer circumferential well region 11 may be 5.0 × 10¹⁷ atoms/cm³ or more and 5.0 × 10¹⁹ atoms/cm³ or less. The impurity concentration of the outer circumferential well region 11 may be 2.0 × 10¹⁸ atoms/cm³ or more and 2.0 × 10¹⁹ atoms/cm³ or less.

In addition, the semiconductor device 100 may include a temperature sensing unit (not shown) which is a PN junction diode formed of polysilicon or the like, and a current detection unit (not shown) which simulates operation of the transistor portion 70 provided in the active portion 160.

The semiconductor device 100 in the present example includes an edge termination structure portion 90 between the active portion 160 and the end side 162 in a top view. The edge termination structure portion 90 in the present example is arranged between the outer circumferential gate runner 130 and the end side 162. The edge termination structure portion 90 reduces electric field strength on the upper surface side of the semiconductor substrate 10. The edge termination structure portion 90 may include at least one of a guard ring, a field plate, or a RESURF which is annularly provided enclosing the active portion 160.

Fig. 2 is an enlarged view of a region D in Fig. 1. The region D is a region including the transistor portion 70. The semiconductor device 100 in the present example includes a gate trench portion 40, a dummy trench portion 30, the outer circumferential well region 11, an emitter region 12, and a contact region 15 which are provided inside on an upper surface side of the semiconductor substrate 10. Each of the gate trench portion 40 and the dummy trench portion 30 is an example of a trench portion.

The semiconductor device 100 in the present example includes an emitter electrode and the gate runner 130 which are provided above an upper surface of the semiconductor substrate 10. The emitter electrode and the gate runner 130 are provided separately from each other. In addition, an interlayer dielectric film is provided between the emitter electrode and the gate runner 130, and the upper surface of the semiconductor substrate 10. In FIG. 2, illustrations of the emitter electrode, the gate runner 130, and the interlayer dielectric film are omitted.

The emitter electrode is provided above the gate trench portion 40, the dummy trench portion 30, the outer circumferential well region 11, the emitter region 12, and the contact region 15. The emitter electrode is in contact with the emitter region 12 and the contact region 15 at the upper surface of the semiconductor substrate 10 through a contact hole. In addition, the emitter electrode is connected to a dummy conductive portion in the dummy trench portion 30 through the contact hole provided in the interlayer dielectric film. The emitter electrode may be connected to the dummy conductive portion of the dummy trench portion 30 at an edge portion 31 of the dummy trench portion 30 in the Y axis direction.

The gate runner 130 is connected to the gate trench portion 40 through the contact hole provided in the interlayer dielectric film. The gate runner 130 may be connected to a gate conductive portion of the gate trench portion 40 at an edge portion 41 of the gate trench portion 40 in the Y axis direction. The gate runner 130 is not connected to the dummy conductive portion in the dummy trench portion 30.

The emitter electrode is formed of a material containing metal. For example, at least a partial region of the emitter electrode is formed of aluminum or an aluminum-silicon alloy, for example, a metal alloy such as AlSi, AlSiCu. The emitter electrode may include a barrier metal formed of titanium, a titanium compound, or the like, below a region formed of aluminum or the like. Furthermore, it may include a plug formed by embedding tungsten or the like so as to be in contact with the barrier metal, aluminum, and the like, in the contact hole.

The transistor portion 70 includes a plurality of trench portions arrayed in an array direction. In the present example, the trench portions are provided in the active portion 160 and the outer circumferential well region 11 at the upper surface of the semiconductor substrate 10. The trench portions are provided in stripes in a top view in the transistor portion 70. One or more gate trench portions 40 and one or more dummy trench portions 30 are alternately provided along the array direction in the transistor portion 70. One gate trench portion 40 and two dummy trench portions 30 may be alternately provided. It should be noted that two gate trench portions 40 may be provided adjacent to each other in at least a partial region.

The gate trench portion 40 in the present example may include two linear portions 39 extending along an extending direction perpendicular to the array direction (trench portions which are linear along the extending direction), and the edge portion 41 connecting the two linear portions 39. In the present specification, the extending direction is the Y axis direction.

At least part of the edge portion 41 is preferably provided in a curved-line shape in a top view. The edge portion 41 connects end portions of the two linear portions 39 in the Y axis direction, so that electric field strength at the end portions of the linear portions 39 can be reduced.

In the transistor portion 70, the dummy trench portion 30 is provided between respective linear portions 39 of the gate trench portion 40. One dummy trench portion 30 may be provided or a plurality of dummy trench portions 30 may be provided, between the respective linear portions 39. In the present example, two dummy trench portions 30 are provided between the respective linear portions 39. It should be noted that the dummy trench portion 30 may not be provided between the linear portions 39 in at least a partial region. The dummy trench portion 30 may have a linear shape extending in the extending direction, or may include linear portions 29 and an edge portion 31 similarly to the gate trench portion 40. In the present example, each dummy trench portion 30 includes the linear portions 29 and the edge portion 31.

A diffusion depth of the outer circumferential well region 11 may be deeper than depths of the gate trench portion 40 and the dummy trench portion 30. End portions of the gate trench portion 40 and the dummy trench portion 30 in the Y axis direction are provided in the outer circumferential well region 11 in a top view. That is, a bottom of each trench portion in the depth direction is covered with the outer circumferential well region 11 at an end portion of each trench portion in the Y axis direction. This can reduce electric field strength at the bottom of each trench portion. In addition, the semiconductor device 100 may include the gate trench portion 40 or the dummy trench portion 30 which is entirely provided in the outer circumferential well region 11 in a top view.

A mesa portion is provided between respective trench portions in the array direction. The mesa portion refers to a region sandwiched between the trench portions inside the semiconductor substrate 10. As an example, an upper end of the mesa portion is the upper surface of the semiconductor substrate 10. A depth position of a lower end of the mesa portion is the same as a depth position of a lower end of the trench portion. The mesa portion in the present example is provided extending in the extending direction (the Y axis direction) along a trench, at the upper surface of the semiconductor substrate 10. In the present example, the transistor portion 70 is provided with a mesa portion 60 and a wide mesa portion 62.

Each mesa portion 60 may be provided with at least one of the emitter region 12 of a first conductivity type or the contact region 15 of a second conductivity type. The emitter region 12 in the present example is of the N++ type, and the contact region 15 is of the P++ type. The emitter region 12 and the contact region 15 may be provided between the base region and the upper surface of the semiconductor substrate 10 in the depth direction.

A mesa width of the wide mesa portion 62 is greater than a mesa width of the mesa portion 60. The mesa width is an interval between the trench portions in the array direction (the X axis direction). In the present specification, the mesa width of the mesa portion 60 is referred to as a first trench interval, and the mesa width of the wide mesa portion 62 is referred to as a second trench interval. Each wide mesa portion 62 may be provided with the contact region 15 of the second conductivity type.

The mesa portion 60 of the transistor portion 70 includes the emitter region 12 exposed on the upper surface of the semiconductor substrate 10. The emitter region 12 is provided in contact with the gate trench portion 40. The mesa portion 60 in contact with the gate trench portion 40 may be provided with the contact region 15 exposed on the upper surface of the semiconductor substrate 10. In the present example, a region exposed on the upper surface of the semiconductor substrate 10 in the mesa portion 60 and arranged closest to the gate runner 130 is the contact region 15. In addition, the emitter region 12 and the contact region 15 may be provided in the wide mesa portion 62 as well. In FIG. 2, the contact region 15 is provided in the wide mesa portion 62.

Each of the contact region 15 and the emitter region 12 in the mesa portion 60 is provided from one trench portion to the other trench portion in the X axis direction. As an example, contact regions 15 and emitter regions 12 of the mesa portion 60 are alternately arranged along the extending direction of the trench portion (the Y axis direction). In addition, the contact region 15 in the wide mesa portion 62 is provided from one trench portion to the other trench portion in the X axis direction.

In another example, the contact regions 15 and the emitter regions 12 of the mesa portion 60 may be provided in stripes along the extending direction of the trench portion (the Y axis direction). For example, the emitter region 12 is provided in a region in contact with the trench portion, and the contact region 15 is provided in a region sandwiched between the emitter regions 12.

In FIG. 2, the edge termination structure portion 90 is provided with a guard ring 92. The edge termination structure portion 90 may be provided with a plurality of guard rings 92. The guard ring 92 is a region of the second conductivity type. An impurity concentration of the guard ring 92 may be the same as that of the outer circumferential well region 11.

The active portion 160 includes a central portion 170 and an outer circumferential portion 180. The central portion 170 includes the emitter region 12. The outer circumferential portion 180 encloses the central portion 170. In the present example, the outer circumferential portion 180 encloses the central portion 170 in a top view. A boundary between the central portion 170 and the outer circumferential portion 180 may be the emitter region 12 closest to the outer circumferential well region 11 in the X axis direction or the Y axis direction.

The contact hole is provided above each mesa portion 60 and wide mesa portion 62 of the central portion 170. The contact hole in the present example is provided above each of the contact region 15 and the emitter region 12. The contact hole may be arranged at a center of the mesa portion 60 in the array direction (the X axis direction). The contact hole may be arranged at a center of the wide mesa portion 62 in the array direction (the X axis direction). In the present example, illustration of the contact hole is omitted.

In FIG. 2, dotted lines indicate arrangement of the first bottom region 182 and the second bottom region 184 which are provided in the semiconductor substrate 10. The first bottom region 182 is a region of the P- type provided over at least two trench portions. The second bottom region 184 is a region of the P- type provided at a bottom of one trench portion. In the present example, the second bottom region 184 is provided in the trench portion sandwiched between wide mesa portions 62. In addition, first bottom regions 182 are provided in the trench portion sandwiched between mesa portions 60 and in the trench portion sandwiched between the mesa portion 60 and the wide mesa portion 62. As shown in FIG. 2, the first bottom region 182 and the second bottom region 184 are provided apart from each other. That is, the first bottom region 182 and the second bottom region 184 are not electrically connected to each other.

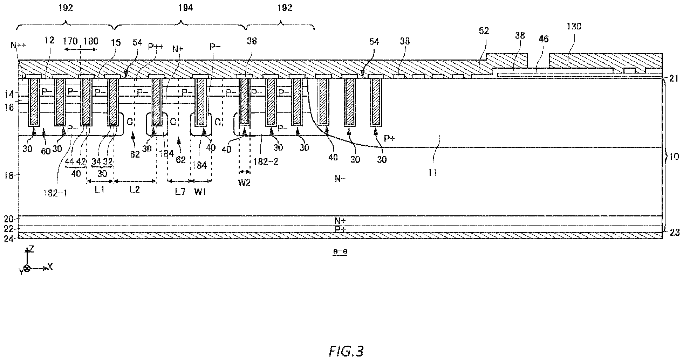

Fig. 3 illustrates an example of a cross section e-e in Fig. 2. The cross section e-e is an XZ plane passing through the emitter region 12 of the central portion 170. It should be noted that the dimensions in FIG. 3 do not necessarily match the dimensions in FIG. 2. The semiconductor device 100 in the present example includes the semiconductor substrate 10, the interlayer dielectric film 38, an emitter electrode 52, and the collector electrode 24 in the cross section.

The interlayer dielectric film 38 is provided on an upper surface 21 of the semiconductor substrate 10. The interlayer dielectric film 38 is a film including at least one of a dielectric film such as silicate glass to which an impurity such as boron or phosphorus is added, a thermal oxide film, or other dielectric films. The interlayer dielectric film 38 is provided with a contact hole 54 described in Fig. 2. The contact hole 54 is partially provided above the outer circumferential well region 11, whereby the outer circumferential well region 11 is connected to the emitter electrode 52.

The emitter electrode 52 is provided above the interlayer dielectric film 38. The emitter electrode 52 is in contact with the upper surface 21 of the semiconductor substrate 10 through the contact hole 54 of the interlayer dielectric film 38. It should be noted that the emitter electrode 52 may not be provided above the outer circumferential well region 11. The gate runner 130 may be provided above the outer circumferential well region 11. A gate polysilicon 46 may be provided under the gate runner 130.

The collector electrode 24 is provided on a lower surface 23 of the semiconductor substrate 10. The emitter electrode 52 and the collector electrode 24 are formed of a metal material such as aluminum. In the present specification, a direction in which the emitter electrode 52 and the collector electrode 24 are connected to each other (Z axis direction) is referred to as the depth direction.

Each mesa portion 60 and wide mesa portion 62 is provided with the base region 14 of a second conductivity type. The emitter region 12 and the contact region 15 are provided between the upper surface 21 of the semiconductor substrate 10 and the base region 14. The base region 14 in the present example is of the P- type.

According to the invention, the semiconductor substrate 10 includes a drift region 18 of a first conductivity type. The drift region 18 in the present example is of the N type or the N- type.

The mesa portion 60 of the central portion 170 is provided with the emitter region 12 of the N++ type and the base region 14 of the P- type in order from a side of the upper surface 21 of the semiconductor substrate 10. The drift region 18 is provided below the base region 14. The mesa portion 60 may be provided with an accumulation region 16 of the N+ type. The accumulation region 16 is arranged between the base region 14 and the drift region 18.

The emitter region 12 is exposed on the upper surface 21 of the semiconductor substrate 10, and is provided in contact with the gate trench portion 40. The emitter region 12 may be in contact with trench portions on both sides of the mesa portion 60. The emitter region 12 has a higher doping concentration than the drift region 18.

The base region 14 is provided below the emitter region 12. The base region 14 in the present example is provided in contact with the emitter region 12. The base region 14 may be in contact with the trench portions on both sides of the mesa portion 60. A peak of an impurity concentration of the base region 14 is 2.5 × 10¹⁷ atoms/cm³, as an example. The impurity concentration of the base region 14 may be 5.0 × 10¹⁶ atoms/cm³ or more and 1.0 × 10¹⁸ atoms/cm³ or less. In addition, the base region 14 may be in contact with trench portions on both sides of the wide mesa portion 62.

The accumulation region 16 is provided below the base region 14. The accumulation region 16 is a region of the N+ type having a higher doping concentration than the drift region 18. The accumulation region 16 may have a concentration peak of a donor such as a phosphorus or hydrogen donor. Providing the accumulation region 16 having a high concentration between the drift region 18 and the base region 14 can improve a carrier injection enhancement effect (IE effect) and reduce an on-voltage. The accumulation region 16 may be provided to entirely cover a lower surface of the base region 14 in each mesa portion 60.

The mesa portion 60 of the outer circumferential portion 180 is provided with the contact region 15 of the P++ type and the base region 14 of the P- type in order from the side of the upper surface 21 of the semiconductor substrate 10. Similarly, the wide mesa portion 62 of the outer circumferential portion 180 may be provided with the contact region 15 of the P++ type and the base region 14 of the P- type in order from the side of the upper surface 21 of the semiconductor substrate 10. The drift region 18 is provided below the base region 14. The accumulation region 16 may be provided in the mesa portion 60 of the outer circumferential portion 180. The accumulation region 16 may be provided in the wide mesa portion 62 of the outer circumferential portion 180.

A buffer region 20 of the N+ type may be provided under the drift region 18. A doping concentration of the buffer region 20 is higher than a doping concentration of the drift region 18. The buffer region 20 may have a concentration peak having a higher doping concentration than the drift region 18. The doping concentration of the concentration peak refers to a doping concentration at a local maximum of the concentration peak. In addition, as the doping concentration of the drift region 18, an average value of doping concentrations in a region where the doping concentration distribution is substantially flat may be used.

The buffer region 20 may be formed through ion implantation of the dopant of the N type such as hydrogen (proton) or phosphorus. The buffer region 20 in the present example is formed through the ion implantation of hydrogen. The buffer region 20 may function as a field stop layer which prevents a depletion layer expanding from a lower end of the base region 14 from reaching a collector region 22 of the P+ type.

The collector region 22 of the P+ type is provided below the buffer region 20. An acceptor concentration of the collector region 22 is higher than an acceptor concentration of the base region 14. The collector region 22 may include an acceptor which is the same as or different from an acceptor of the base region 14. The acceptor of the collector region 22 is, for example, boron. The element serving as the acceptor is not limited to the example described above.

The collector region 22 is exposed on the lower surface 23 of the semiconductor substrate 10, and is connected to the collector electrode 24. The collector electrode 24 may be in contact with the entire lower surface 23 of the semiconductor substrate 10. The emitter electrode 52 and the collector electrode 24 are formed of a metal material such as aluminum.

One or more gate trench portions 40 and one or more dummy trench portions 30 are provided on the side of the upper surface 21 of the semiconductor substrate 10. Each trench portion extends from the upper surface 21 of the semiconductor substrate 10 through the base region 14, to reach the drift region 18. In a region provided with at least any of the emitter region 12, the contact region 15, or the accumulation region 16, each trench portion also extends through these doping regions, to reach the drift region 18. A configuration of the trench portions extending through the doping regions is not limited to what is manufactured in an order of forming the doping regions and then forming the trench portions. The configuration of the trench portions extending through the doping regions also includes a configuration of forming the trench portions and then forming the doping regions between the trench portions.

The gate trench portion 40 includes a gate trench, a gate dielectric film 42, and a gate conductive portion 44 which are provided at the upper surface 21 of the semiconductor substrate 10. The gate dielectric film 42 is provided covering an inner wall of the gate trench. The gate dielectric film 42 may be formed by oxidizing or nitriding a semiconductor on the inner wall of the gate trench. The gate conductive portion 44 is provided farther inward inside the gate trench than the gate dielectric film 42. That is, the gate dielectric film 42 insulates the gate conductive portion 44 from the semiconductor substrate 10. The gate conductive portion 44 is formed of a conductive material such as polysilicon.

The gate conductive portion 44 may be provided longer than the base region 14 in the depth direction. The gate trench portion 40 in the cross section is covered by the interlayer dielectric film 38 on the upper surface 21 of the semiconductor substrate 10. The gate conductive portion 44 is electrically connected to the gate runner 130. When a predetermined gate voltage is applied to the gate conductive portion 44, a channel is formed by an electron inversion layer in a surface layer of the base region 14 at a boundary surface in contact with the gate trench portion 40.

The dummy trench portion 30 may have the same structure as that of the gate trench portions 40 in the cross section. The dummy trench portion 30 includes a dummy trench, a dummy dielectric film 32, and a dummy conductive portion 34 which are provided at the upper surface 21 of the semiconductor substrate 10. The dummy conductive portion 34 is electrically connected to the emitter electrode 52. The dummy dielectric film 32 is provided covering an inner wall of the dummy trench. The dummy conductive portion 34 is provided inside the dummy trench, and is provided farther inward than the dummy dielectric film 32. The dummy dielectric film 32 insulates the dummy conductive portion 34 from the semiconductor substrate 10. The dummy conductive portion 34 may be formed of the same material as that of the gate conductive portion 44. For example, the dummy conductive portion 34 is formed of the conductive material such as polysilicon. The dummy conductive portion 34 may have the same length as that of the gate conductive portion 44 in the depth direction.

The gate trench portion 40 and the dummy trench portion 30 in the present example are covered with the interlayer dielectric film 38 on the upper surface 21 of the semiconductor substrate 10. It should be noted that bottoms of the dummy trench portion 30 and the gate trench portion 40 may have a curved-surface shape (a curved-line shape in the cross section) protruding downward.

In the semiconductor device 100 according to the invention, a bottom region of the second conductivity type is provided at a bottom of the trench portion. In the present example, the central portion 170 is provided with a first bottom region 182-1 of the second conductivity type at the bottom of the trench portion. The first bottom region 182-1 is the first bottom region 182 provided on a side of the central portion 170 relative to the first bottom region 182-2. The first bottom region 182-1 in the present example is of the P- type. The first bottom region 182-1 covers the bottom of the trench portion. According to the invention, the first bottom region 182-1 is provided over bottoms of at least two trench portions. The first bottom region 182-1 may be provided below the base region 14. Providing the first bottom region 182-1 of the second conductivity type makes it easy to control a slope of a reverse recovery voltage of an FWD. Accordingly, a turn-on loss can be reduced. In addition, providing the first bottom region 182-1 can improve a breakdown voltage.

In addition, according to the invention, the the outer circumferential portion 180 is provided with the first bottom region 182-2 of the second conductivity type at the bottom of the trench portion. The first bottom region 182-2 is the first bottom region 182 provided on a side of the outer circumferential portion 180 relative to the first bottom region 182-1. The first bottom region 182-2 in the present example is of the P- type. The first bottom region 182-2 covers the bottom of the trench portion. The first bottom region 182-2 may be provided toward the first bottom region 182-1. That is, the first bottom region 182-2 may be provided at the same depth as that of the first bottom region 182-1 in the depth direction of the semiconductor substrate 10. According to the invention, the first bottom region 182-2 is electrically connected to the outer circumferential well region 11. In the present example, the first bottom region 182-2 is directly connected to the outer circumferential well region 11. Accordingly, it is possible to reduce electric field strength at a boundary between the outer circumferential well region 11 and the first bottom region 182-2, and to improve avalanche capability at turn-off.

The first bottom region 182-1 and the first bottom region 182-2 are provided apart from each other. That is, the bottom region is not provided in at least part of the outer circumferential portion 180. Providing the first bottom region 182-1 and the first bottom region 182-2 apart from each other can prevent the first bottom region 182-1 and the outer circumferential well region 11 from being at the same potential. The first bottom region 182-1 may be electrically floating. The first bottom region 182-1 is electrically floating if it is not electrically connected to any electrode.

An impurity concentration of the first bottom region 182-1 may be the same as an impurity concentration of the first bottom region 182-2. Making the impurity concentrations of the first bottom region 182-1 and the first bottom region 182-2 the same can make manufacturing processes the same. In addition, the impurity concentration of the first bottom region 182-2 may be higher than the impurity concentration of the first bottom region 182-1. Making the impurity concentration of the first bottom region 182-2 higher than the impurity concentration of the first bottom region 182-1 increases an effect of reducing local electric field strength. An impurity concentration of the outer circumferential well region 11 may be higher than the impurity concentration of the first bottom region 182-2. Making the impurity concentration of the outer circumferential well region 11 higher than the impurity concentration of the first bottom region 182-2 can prevent electric field distribution from becoming steep. A peak of the impurity concentration of each bottom region is, as an example, 4.0 × 10¹⁵ atoms/cm³. The peak of the impurity concentration of each bottom region may be 3.0 × 10¹⁴ atoms/cm³ or more and 3.0 × 10¹⁶ atoms/cm³ or less. A dose amount of ions implanted into each bottom region may be, as an example, 5.0 × 10¹¹ ions/cm² or more and 5.0 × 10¹³ ions/cm² or less.

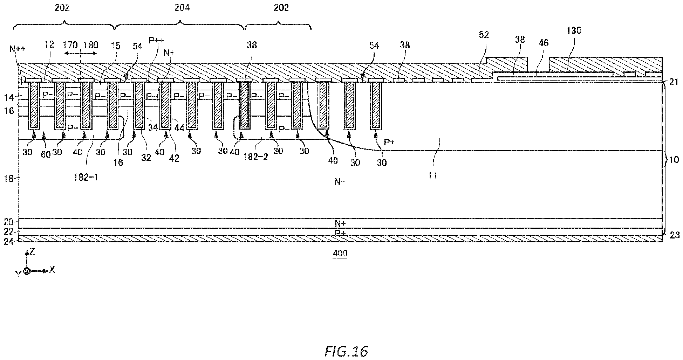

In a semiconductor device 400 (see FIG. 16) according to a comparative example, there is an imbalance of an active static breakdown voltage of an IGBT generated, in the active portion 160, between a region in which the trench portion has the bottom region (referred to as a region 202) and a region in which the trench portion does not have the bottom region (a region 204) depending on presence or absence of the bottom region. According to a simulation performed by the inventor, the static breakdown voltage of the region 204 is lower than that of the region 202 by about 5%. It is estimated that a difference in the static breakdown voltage is several tens of volts to 100 V depending on the breakdown voltage of the IGBT. For a similar reason, it is estimated that a clamp breakdown voltage of the region 204 is also lower than that of the region 202. Due to a breakdown voltage imbalance, there is a higher possibility that the IGBT undergoes switching breakdown intensively in the region 204.

In FIG. 3, the active portion 160 includes a first region 192 and a second region 194. The first region 192 is a region in which the trench portions are arrayed at a first trench interval L1 in an array direction. The second region 194 is a region in which the trench portions are arrayed at a second trench interval L2 greater than the first trench interval L1 in the array direction. In the present example, the first region 192 is provided in the central portion 170 and the outer circumferential portion 180. In the present example, the second region 194 is provided in the outer circumferential portion 180.

According to the invention, in the case of the bottom region formed in the first region 192, an impurity such as boron is implanted into the trench portion. Subsequently, heat treatment is performed to diffuse boron. A trench interval in the first region 192 is smaller than that in the second region 194. Accordingly, bottom regions provided in adjacent trench portions are connected to each other when boron is diffused. Therefore, the first bottom region 182 provided over at least two trench portions is formed in the first region 192. In the present example, the first region 192 corresponds to the mesa portion 60, and the second region 194 corresponds to the wide mesa portion 62.

On the other hand, according to the invention, in the case of the bottom region formed in the second region 194, since a trench interval in the second region 194 is greater than that in the first region 192, bottom regions provided in adjacent trench portions are not connected to each other when boron is diffused. Therefore, the second bottom region 184 provided at a bottom of one trench portion is formed in the second region 194. Providing the second bottom region 184 can reduce the breakdown voltage imbalance in the active portion 160. In addition, the second bottom region 184 being provided at the bottom of one trench portion can prevent the first bottom region 182-1 and the outer circumferential well region 11 from being at the same potential. Accordingly, a turn-on loss can be reduced.

The second trench interval L2 may be 1.3 times or greater and eight times or smaller the first trench interval L1. The second trench interval L2 may be 1.5 times or greater and six times or smaller the first trench interval L1. The second trench interval L2 may be twice or greater and four times or smaller the first trench interval L1. The first trench interval L1 is, as an example, 0.4 µm or greater and 2.0 µm or smaller. The second trench interval L2 is, as an example, 0.8 µm or greater and 8.0 µm or smaller. Setting the first trench interval L1 and the second trench interval L2 in this manner can reduce the breakdown voltage imbalance.

In the present example, the second region 194 includes the gate trench portion 40. In addition, the second bottom region 184 is provided at the bottom of the gate trench portion 40. The second region 194 including the gate trench portion 40 makes it easy for current to flow through the wide mesa portion 62.

In addition, in the present example, the second region 194 includes the dummy trench portion 30. In addition, the second bottom region 184 is provided at the bottom of the dummy trench portion 30. Such a configuration can also resolve the breakdown voltage imbalance.

The second region 194 may be provided with at least two trench portions. The second bottom region 184 may be provided at a bottom of each of the two trench portions. It should be noted that, in the present example, the second region 194 includes one gate trench portion 40 and one dummy trench portion 30, but the present invention is not limited to this example. For example, the second region 194 may include only one gate trench portion 40. The second region 194 may include only one dummy trench portion 30. The second region 194 may include one or more gate trench portions 40 and one or more dummy trench portions 30.

According to the invention, at least part of the second region 194 is sandwiched between two first regions 192 in the array direction. The second region 194 is sandwiched between the two first regions 192 in the X axis direction. The second region 194 being sandwiched between the two first regions 192 can prevent the first bottom region 182-1 and the first bottom region 182-2 from being electrically connected to each other. In addition, the first bottom region 182-2 provided in one first region 192 of the two first regions 192 is electrically connected to the outer circumferential well region 11.

In addition, the second bottom region 184 is not provided at a center C of the wide mesa portion 62 in the array direction. The second bottom region 184 being not provided at the center C of the wide mesa portion 62 in the array direction can prevent the second bottom region 184 from being connected to another adjacent second bottom region 184. In the present example, part of the drift region 18 is provided between two second bottom regions 184 which are adjacent to each other in the array direction. Therefore, the two second bottom regions 184 which are adjacent to each other in the array direction are not connected to each other.

The second trench interval L2 may be greater than a length W1 of the second bottom region 184 in the array direction. The second trench interval L2 may be greater than 1.6 times the length W1 of the second bottom region 184 in the array direction. Such a configuration can prevent the two second bottom regions 184 which are adjacent to each other in the array direction from being connected to each other.

In addition, according to the invention, the second bottom region 184 covers the bottom of the trench portion. That is, the length W1 of the second bottom region 184 in the array direction may be greater than a length W2 of the trench portion in the array direction. The length W2 of the trench portion in the array direction may be a length of the bottom of the trench portion in the array direction. The second bottom region 184 covering the bottom of the trench portion disperses a hole current and can prevent current crowding.

An impurity concentration of the second bottom region 184 may be the same as an impurity concentration of the first bottom region 182. Making the impurity concentrations of the second bottom region 184 and the first bottom region 182 the same can make manufacturing processes the same.

The impurity concentration of the second bottom region 184 may be different from the impurity concentration of the first bottom region 182. In addition, the second bottom region 184 may be provided toward the first bottom region 182. That is, the second bottom region 184 may be provided at the same depth as that of the first bottom region 182 in the depth direction of the semiconductor substrate 10.

A distance L7 between second bottom regions 184 which are adjacent to each other in the array direction may be 0.1 µm or greater and 10 µm or smaller. Similarly, a distance between the second bottom region 184 and the first bottom region 182 which are adjacent to each other in the array direction may be 0.1 µm or greater and 10 µm or smaller.

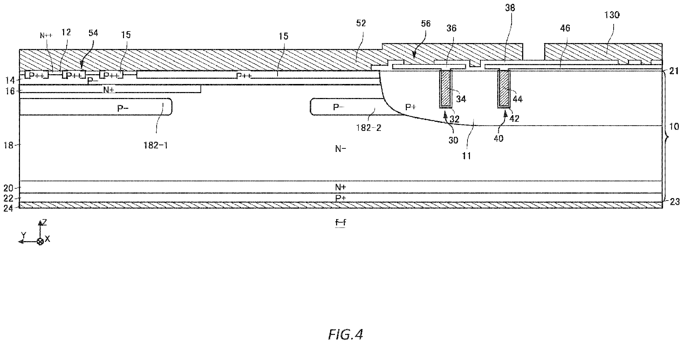

FIG. 4 illustrates an example of a cross section f-f in FIG. 2. The cross section f-f is a YZ plane passing through the edge portion 41 of the gate trench portion 40 and the edge portion 31 of the dummy trench portion 30. It should be noted that the dimensions in FIG. 4 do not necessarily match the dimensions in FIG. 2. The semiconductor device 100 in the present example includes the semiconductor substrate 10, the interlayer dielectric film 38, the emitter electrode 52, the collector electrode 24, and the gate runner 130 in the cross section.

In the cross section, the gate trench portion 40 is connected to the gate runner 130. A gate polysilicon 46 may be provided under the gate runner 130. In the cross section, the dummy trench portion 30 is connected to the emitter electrode 52 via a contact hole 56. A dummy polysilicon 36 may be provided under the emitter electrode 52. In addition, in FIG. 4 and as in FIG. 3, the first bottom region 182-2 may be provided at the same depth as that of the first bottom region 182-1 in the depth direction of the semiconductor substrate 10.

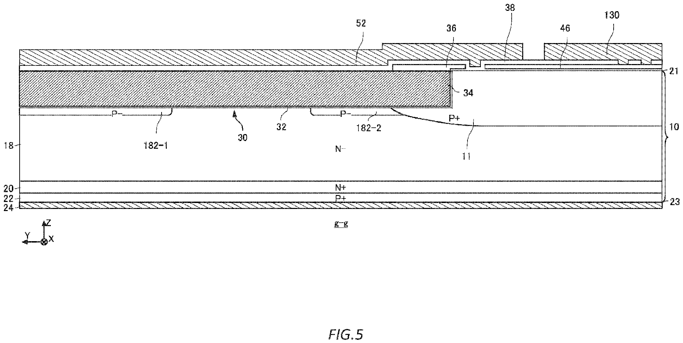

FIG. 5 illustrates an example of a cross section g-g in FIG. 2. The cross section g-g is a YZ plane passing through a linear portion 29 of the dummy trench portion 30. It should be noted that the dimensions in FIG. 5 do not necessarily match the dimensions in FIG. 2. The semiconductor device 100 in the present example includes the semiconductor substrate 10, the interlayer dielectric film 38, the emitter electrode 52, the collector electrode 24, and the gate runner 130 in the cross section. In FIG. 5, the interlayer dielectric film 38 is provided between the emitter electrode 52 and the dummy trench portion 30. In FIG. 5 and as in FIG. 3, the first bottom region 182-2 may be provided at the same depth as that of the first bottom region 182-1 in the depth direction of the semiconductor substrate 10.

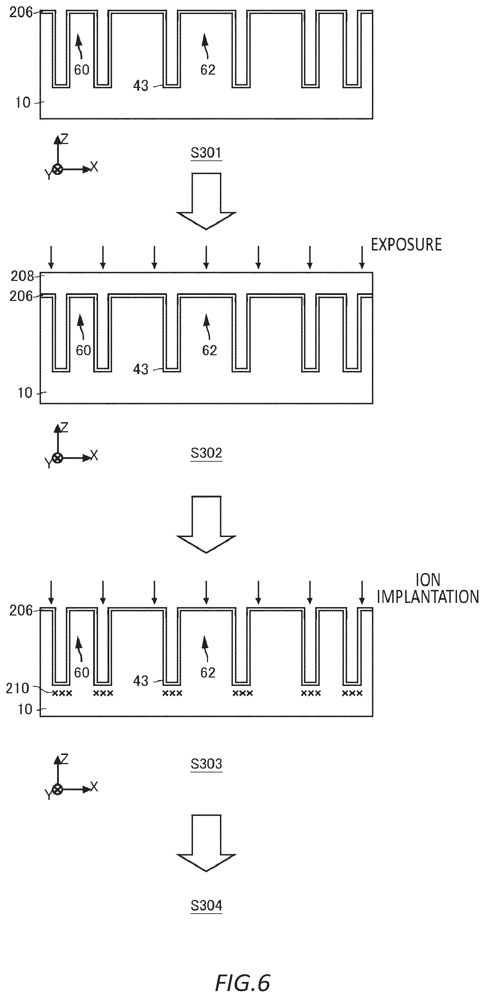

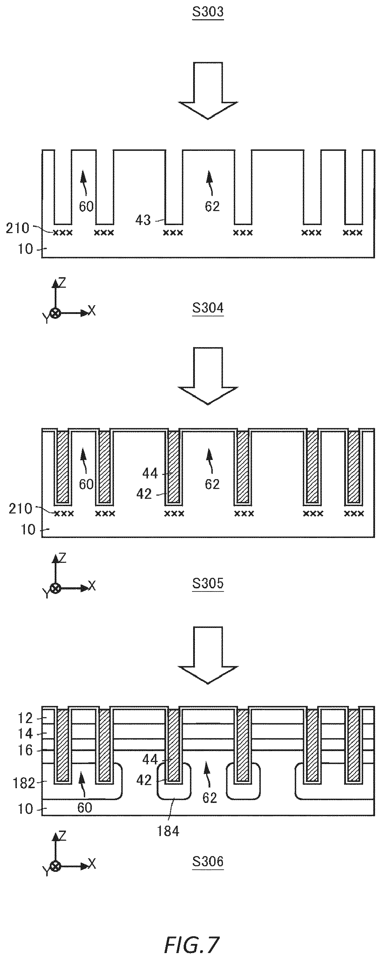

FIG. 6 and FIG. 7 illustrate an example of a method for manufacturing the semiconductor device 100. The method is not claimed but it is useful for understanding the invention. The method for manufacturing the semiconductor device 100 includes a trench formation step S301, a resist formation step S302, an ion implantation step S303, a resist removal step S304, a gate conductive portion formation step S305, and a heat treatment step S306. FIG. 6 describes the trench formation step S301, the resist formation step S302, and the ion implantation step S303. FIG. 7 describes the resist removal step S304, the gate conductive portion formation step S305, and the heat treatment step S306.

In the trench formation step S301, a trench 43 is formed in the semiconductor substrate 10. The trench 43 may be formed by a well-known method. The trench 43 may be formed by etching. In the present example, the mesa portion 60 and the wide mesa portion 62 are formed by forming trenches 43. The trench 43, the mesa portion 60, and the wide mesa portion 62 may be provided with a sacrificial oxide film 206.

In the resist formation step S302, a resist 208 is formed above the semiconductor substrate 10. The resist 208 may be formed by a well-known method such as photolithography. In the resist formation step S302, the resist 208 may be exposed and developed. It should be noted that the resist 208 is not provided in the ion implantation step S303 in this cross section, but the resist 208 may be provided in another cross section.

In the ion implantation step S303, ions are implanted into the semiconductor substrate 10. In the present example, boron is implanted into the semiconductor substrate 10. Acceleration energy for ion implantation is, as an example, 100 keV. An implantation region 210 is formed at a bottom of the trench 43 by performing the ion implantation. A bottom region can be formed by heat-treating the implantation region 210.

In the resist removal step S304, the resist 208 is removed. In the resist removal step S304, the resist 208 may be ashed. It should be noted that, in the resist removal step S304, the sacrificial oxide film 206 may be removed.

In the gate conductive portion formation step S305, the gate conductive portion 44 is formed inside the trench 43. The gate conductive portion 44 may be polysilicon or the like. The gate dielectric film 42 may be provided between the gate conductive portion 44 and the trench 43. It should be noted that the gate dielectric film 42 may be provided in the mesa portion 60 and the wide mesa portion 62.

In the heat treatment step S306, the semiconductor substrate 10 is heat-treated. In the present example, the semiconductor substrate 10 is heat-treated after the ions are implanted into a region in which the emitter region 12, the base region 14, the accumulation region 16, and the contact region 15 (not shown) are formed. If the heat treatment is performed, in the mesa portion 60, bottom regions provided in adjacent trench portions are connected to each other when boron is diffused, so that the first bottom region 182 is formed. On the other hand, in the wide mesa portion 62, bottom regions provided in adjacent trench portions are not connected to each other when boron is diffused, so that the second bottom region 184 is formed.

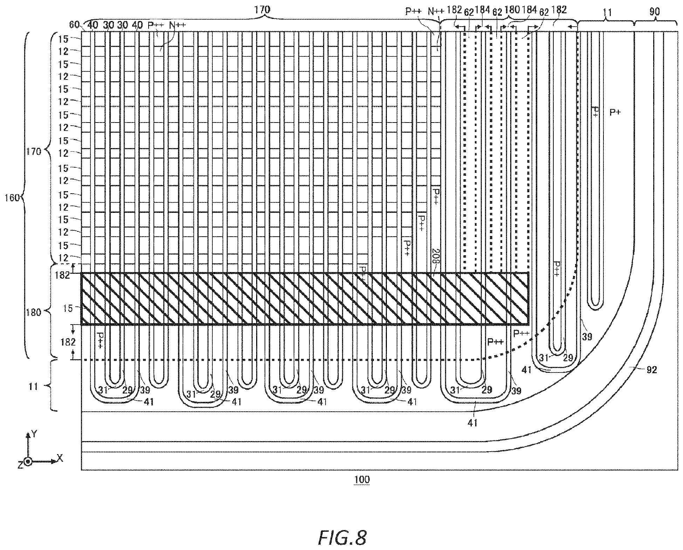

FIG. 8 illustrates an example of arrangement of the resist 208 provided in the resist formation step S302. In FIG. 8, the resist 208 is arranged in the region D in FIG. 1. The resist 208 may have a longitudinal length in an array direction. The resist 208 may be provided in the outer circumferential portion 180.

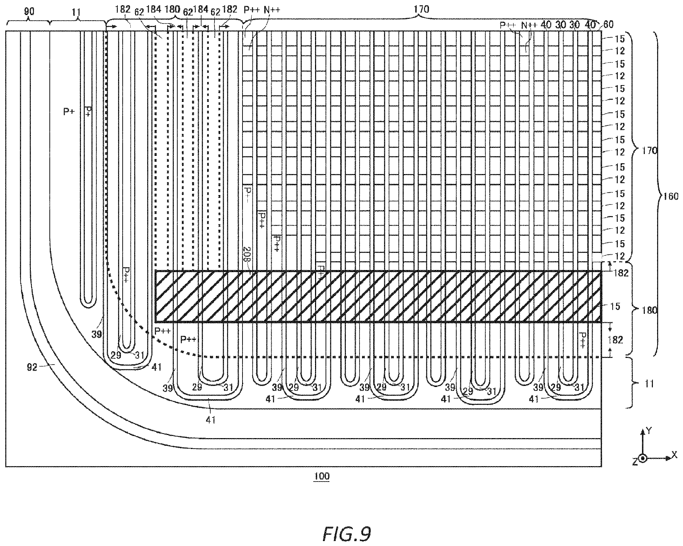

FIG. 9 illustrates an example of arrangement of the resist 208 provided in the resist formation step S302. In FIG. 9, the resist 208 is arranged in a region E in FIG. 1. Arrangement of each component in the region E may be arrangement of each component in the region D which is inverted with respect to the Y axis. As in FIG. 8, the resist 208 may have a longitudinal length in an array direction. The resist 208 may be provided in the outer circumferential portion 180.

The resist 208 may be provided so as not to connect the first bottom region 182 provided on a side of the central portion 170 (the first bottom region 182-1 in FIG. 3) and the first bottom region 182 provided on a side of the outer circumferential portion 180 (the first bottom region 182-2 in FIG. 3). The resist 208 may terminate in the wide mesa portion 62. In the present example, the resist 208 is provided continuously from the wide mesa portion 62 in FIG. 8 to the wide mesa portion 62 in FIG. 9.

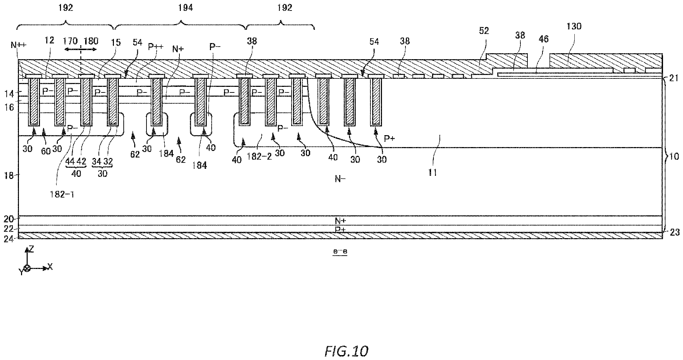

Fig. 10 illustrates another example of the cross section e-e in Fig. 2. FIG. 10 is different from FIG. 3 in that the first bottom region 182-2 is provided wider than the first bottom region 182-1 in the depth direction of the semiconductor substrate 10. Other than this point, FIG. 10 may have the same configuration as that in FIG. 3. In the present example, the first bottom region 182-2 is provided wider than the first bottom region 182-1 on a side of the lower surface 23, and has much the same depth as that of the outer circumferential well region 11. Providing the first bottom region 182-2 wider than the first bottom region 182-1 can adjust electric field distribution. In addition, the first bottom region 182-2 may be provided wider than the second bottom region 184 in the depth direction of the semiconductor substrate 10.

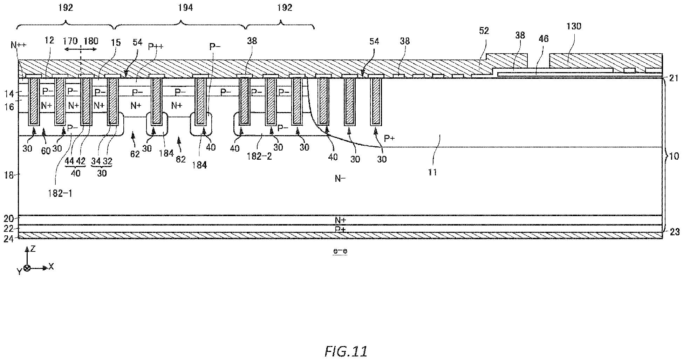

FIG. 11 illustrates another example of the cross section e-e in FIG. 2. FIG. 11 is different from FIG. 3 in a configuration of the accumulation region 16. Other than this point, FIG. 11 may have the same configuration as that in FIG. 3.

In the present example, part of the accumulation region 16 is provided between two second bottom regions 184 which are adjacent to each other in an array direction. Such a configuration can also reduce a breakdown voltage imbalance in the active portion 160. An upper end of the second bottom region 184 may be in contact with a lower end of the accumulation region 16 in the depth direction of the semiconductor substrate 10. The upper end of the second bottom region 184 being in contact with the lower end of the accumulation region 16 can improve a withstand capability of the semiconductor device 100. It should be noted that an upper end of the first bottom region 182-1 may be in contact with the lower end of the accumulation region 16 in the depth direction of the semiconductor substrate 10.

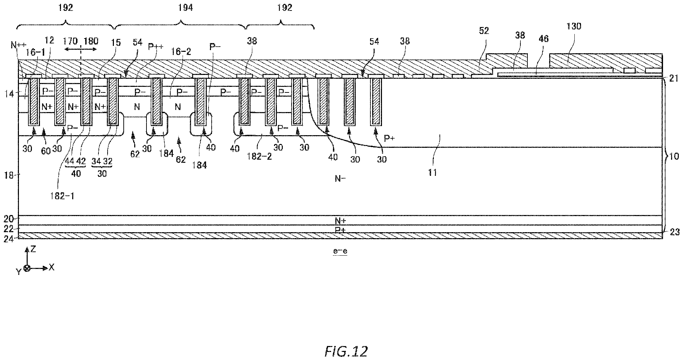

FIG. 12 illustrates another example of the cross section e-e in FIG. 2. FIG. 12 is different from FIG. 11 in a configuration of the accumulation region 16. Other than this point, FIG. 12 may have the same configuration as that in FIG. 11.

In the present example, the accumulation region 16 provided in the first region 192 is referred to as an accumulation region 16-1, and the accumulation region 16 provided in the second region 194 is referred to as an accumulation region 16-2. A doping concentration of the accumulation region 16-2 provided in the second region 194 may be lower than a doping concentration of the accumulation region 16-1 provided in the first region 192. Since a high doping concentration of the accumulation region 16 tends to decrease a breakdown voltage, a breakdown voltage imbalance can be resolved by decreasing the doping concentration of the accumulation region 16-2 provided in the second region 194 where the breakdown voltage easily decreases.

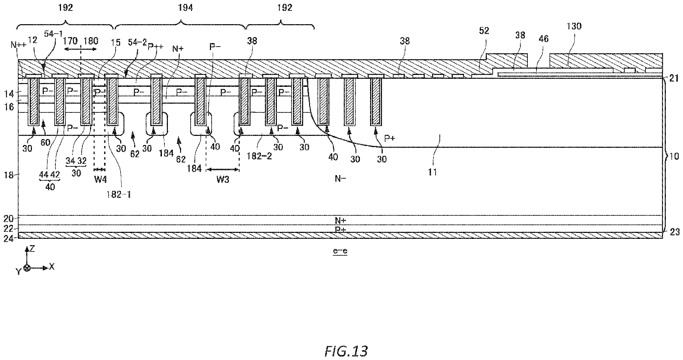

FIG. 13 illustrates another example of the cross section e-e in FIG. 2. FIG. 13 is different from FIG. 3 in a configuration of the contact hole 54. Other than this point, FIG. 13 may have the same configuration as that in FIG. 3.

In the present example, the contact hole 54 provided above the first region 192 is referred to as a contact hole 54-1, and the contact hole 54 provided above the second region 194 is referred to as a contact hole 54-2. An opening width W3 of the contact hole 54-2 provided above the second region 194 may be greater than an opening width W4 of the contact hole 54-1 provided above the first region 192. Since the contact region 15 is exposed in the contact hole 54-2 provided above the second region 194, hole extraction can be improved by increasing the opening width W3 of the contact hole 54-2. Accordingly, latch-up of the semiconductor device 100 can be suppressed. In the present example, the opening width W3 of the contact hole 54-2 is the same as the second trench interval L2 (see FIG. 3).

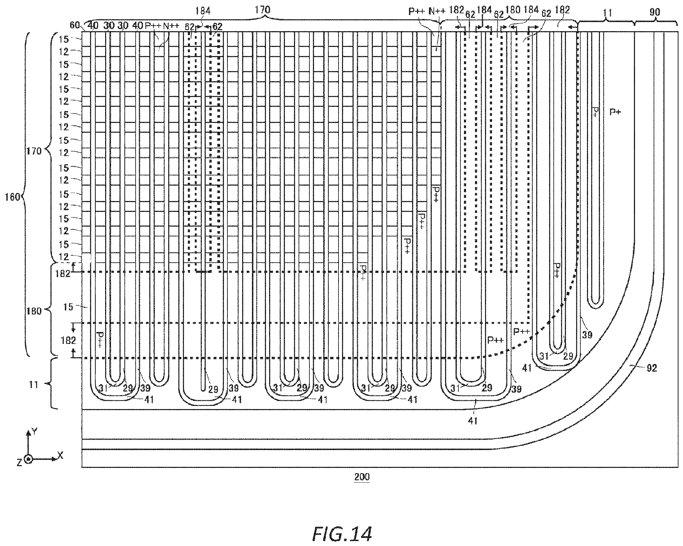

FIG. 14 is a top view showing an example of a semiconductor device 200 according to another exemplary embodiment. FIG. 14 is different from FIG. 2 in that the wide mesa portion 62 is provided in the central portion 170. Other than this point, FIG. 14 may have the same configuration as that in FIG. 2.

In the present example, the wide mesa portion 62 is provided in the central portion 170. Accordingly, the second bottom region 184 can be formed in the central portion 170. Thus, a breakdown voltage imbalance of the semiconductor device 200 can be adjusted. In the present example, a trench portion provided with the second bottom region 184 is the dummy trench portion 30. The trench portion provided with the second bottom region 184 may be the gate trench portion 40. In addition, a plurality of second bottom regions 184 may be formed in the central portion 170. A trench interval for the wide mesa portion 62 provided in the central portion 170 may be the same as or different from a trench interval for the wide mesa portion 62 provided in the outer circumferential portion 180.

In the present example, an area ratio between the emitter region 12 and the contact region 15 in the wide mesa portion 62 provided in the central portion 170 is the same as an area ratio between the emitter region 12 and the contact region 15 in the mesa portion 60 provided in the central portion 170. The area ratio between the emitter region 12 and the contact region 15 is, for example, area of the emitter region 12/area of the contact region 15 in unit length in an extending direction. It should be noted that, in the present example, the area ratio between the emitter region 12 and the contact region 15 is a length of one emitter region 12 in the extending direction/a length of one contact region 15 in the extending direction because the emitter region 12 and the contact region 15 are provided from one trench portion to the other trench portion in the X axis direction in the mesa portion 60 and the wide mesa portion 62.

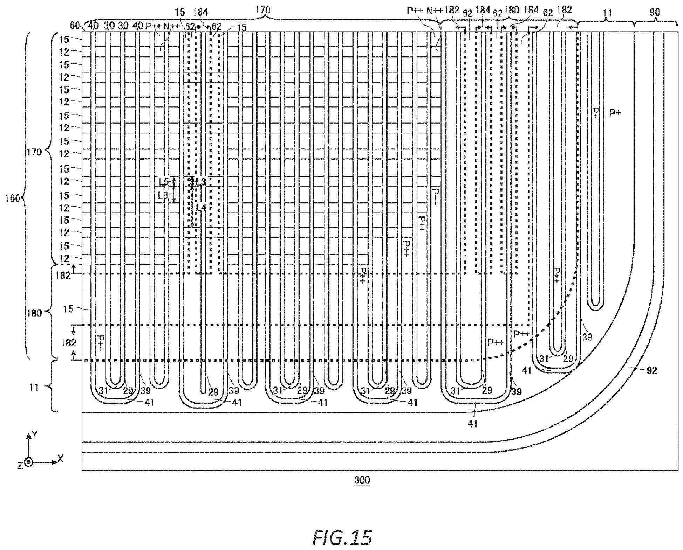

FIG. 15 is a top view showing an example of a semiconductor device 300 according to another exemplary embodiment. FIG. 15 is different from FIG. 14 in a configuration of the emitter region 12 and the contact region 15 which are provided in the wide mesa portion 62. Other than this point, FIG. 15 may have the same configuration as that in FIG. 14.

In the present example, an area ratio between the emitter region 12 and the contact region 15 in the wide mesa portion 62 provided in the central portion 170 is different from an area ratio between the emitter region 12 and the contact region 15 in the mesa portion 60 provided in the central portion 170. In FIG. 15, the area ratio between the emitter region 12 and the contact region 15 in the wide mesa portion 62 provided in the central portion 170 is smaller than the area ratio between the emitter region 12 and the contact region 15 in the mesa portion 60 provided in the central portion 170. A length of one emitter region 12 in an extending direction in the wide mesa portion 62 is referred to as L3, and a length of one contact region 15 in the extending direction in the wide mesa portion 62 is referred to as L4. In addition, a length of one emitter region 12 in the extending direction in the mesa portion 60 is referred to as L5, and a length of one contact region 15 in the extending direction in the mesa portion 60 is referred to as L6. L3/L4 may be smaller than L5/L6. That is, the wide mesa portion 62 provided in the central portion 170 may have a higher proportion of the contact region 15 than the mesa portion 60 provided in the central portion 170. Such a configuration can also improve hole extraction and suppress latch-up of the semiconductor device 300.

FIG. 16 illustrates an example of a semiconductor device 400 according to a comparative example. FIG. 16 is different from FIG. 3 in that the wide mesa portion 62 and the second bottom region 184 are not provided. Other than this point, FIG. 16 may have the same configuration as that in FIG. 3.

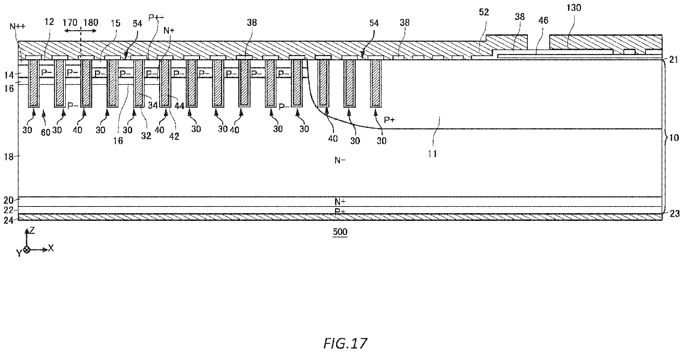

FIG. 17 illustrates an example of a semiconductor device 500 according to a comparative example. FIG. 17 is different from FIG. 16 in that the first bottom region 182 is not provided. Other than this point, FIG. 17 may have the same configuration as that in FIG. 16.

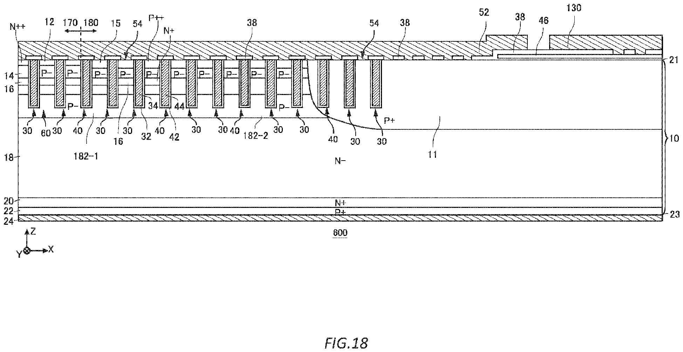

FIG. 18 illustrates an example of a semiconductor device 600 according to a comparative example. FIG. 18 is different from FIG. 16 in that the first bottom region 182-1 and the first bottom region 182-2 are connected to each other. Other than this point, FIG. 18 may have the same configuration as that in FIG. 16. In the present example, a boundary between the first bottom region 182-1 and the first bottom region 182-2 may be a boundary between the central portion 170 and the outer circumferential portion 180.

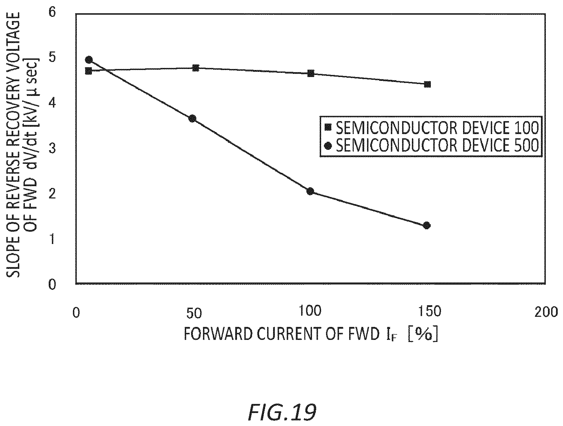

FIG. 19 illustrates relationships between a forward current and a slope of a reverse recovery voltage, of an FWD at room temperature. The forward current is indicated by a percentage with a rated current as 1. The semiconductor device 100 and the semiconductor device 500 in FIG. 19 adjust an external gate resistance so as to have the same slope (about 5 kV/µsec) of the reverse recovery voltage when the forward current is 5 to 10% (at low current). As shown in FIG. 19, the semiconductor device 100 can maintain the slope of the reverse recovery voltage of the FWD to the same degree even when the forward current is changed, as compared to the semiconductor device 500. Accordingly, when the forward current is 100% (at rated current), a turn-on speed on a side of an IGBT does not slow down and can be maintained as fast as when the forward current is 5 to 10% (at low current), so that a turn-on loss can be reduced.

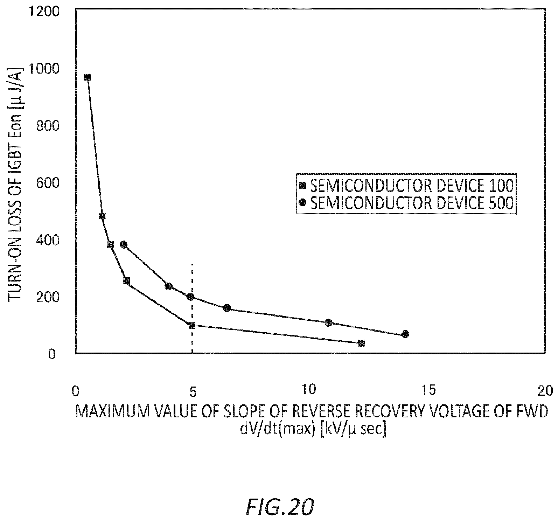

FIG. 20 illustrates relationships between a maximum value of a slope of a reverse recovery voltage of an FWD (at room temperature and low current) and a turn-on loss (at high temperature and rated current). FIG. 20 can be obtained by changing an external gate resistance and plotting the maximum value of the slope of the reverse recovery voltage on a side of the FWD and the turn-on loss on a side of an IGBT on a one-to-one basis. As shown in FIG. 20, when the semiconductor device 100 is compared to the semiconductor device 500 with the maximum value of the slope of the reverse recovery voltage of the FWD as 5 kV/µsec, the turn-on loss can be reduced by about 50 percent.

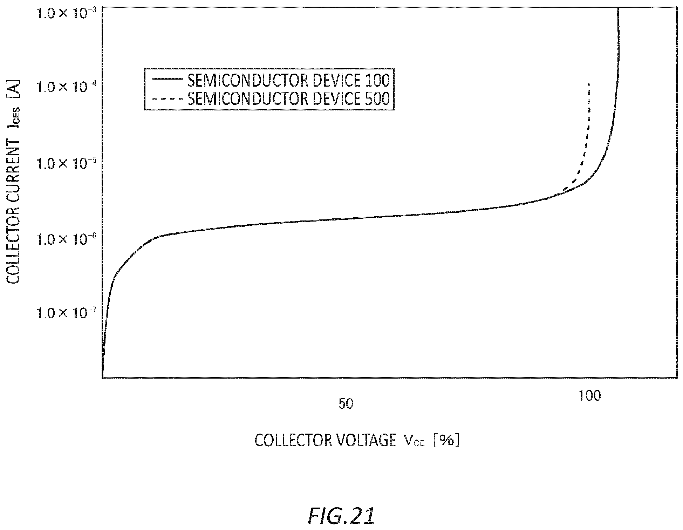

FIG. 21 illustrates I-V characteristics between a collector current and a collector voltage when a gate voltage is 0 V (OFF) for the semiconductor device 100 and the semiconductor device 500. The collector voltage is indicated by a percentage with a breakdown voltage of the semiconductor device 500 as 1. As shown in FIG. 21, the semiconductor device 100 includes a bottom region, so that a breakdown voltage can be improved as compared to the semiconductor device 500.

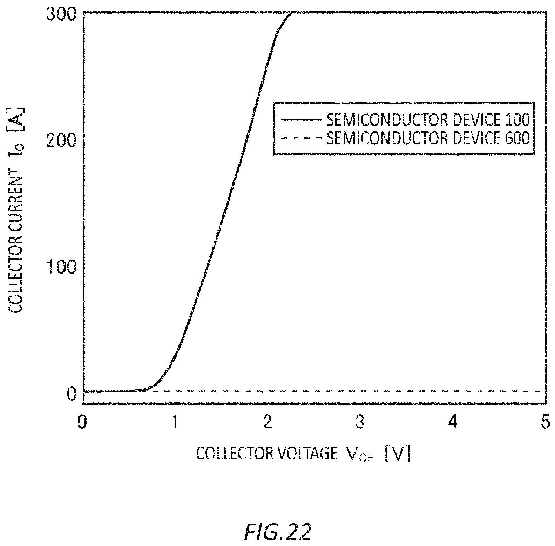

FIG. 22 illustrates I-V characteristics between a collector current and a collector voltage when a gate voltage is 15 V (ON) for the semiconductor device 100 and the semiconductor device 600. As shown in FIG. 22, if the first bottom region 182-1 and the first bottom region 182-2 are connected to each other, the semiconductor device 600 does not operate.

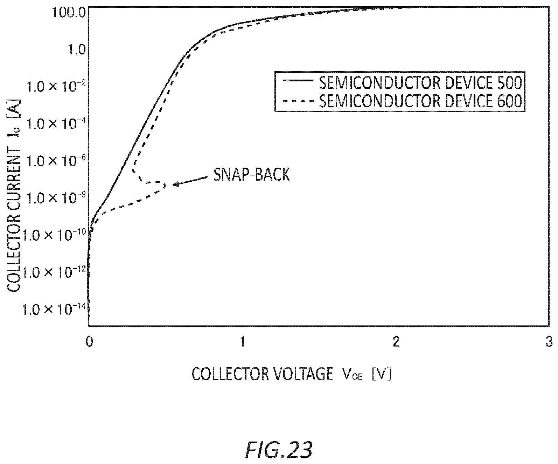

FIG. 23 illustrates I-V characteristics between a collector current and a collector voltage for the semiconductor device 500 and the semiconductor device 600. As shown in FIG. 23, if the first bottom region 182-1 and the first bottom region 182-2 are connected to each other in the semiconductor device 600, a snap-back is generated in an I-V characteristic. Keeping the first bottom region 182-1 and the first bottom region 182-2 from being connected to each other can prevent generation of the snap-back.

It should be noted that the operations, procedures, steps, stages, and the like of each processing performed by an apparatus, system, program, and method shown in the claims, specification, or drawings can be performed in any order as long as the order is not indicated by "prior to," "before," or the like and as long as the output from a previous processing is not used in a later processing. Even if the operation flow is described using phrases such as "first" or "next" for the sake of convenience in the claims, specification, or drawings, it does not necessarily mean that the process must be performed in this order.

### EXPLANATION OF REFERENCES

10: semiconductor substrate, 11: outer circumferential well region, 12: emitter region, 14: base region, 15: contact region, 16: accumulation region, 18: drift region, 20: buffer region, 21: upper surface, 22: collector region, 23: lower surface, 24: collector electrode, 29: linear portion, 30: dummy trench portion, 31: edge portion, 32: dummy dielectric film , 34: dummy conductive portion, 36: dummy polysilicon, 38: interlayer dielectric film, 39: linear portion, 40: gate trench portion, 41: edge portion, 42: gate dielectric film , 43: trench, 44: gate conductive portion, 46: gate polysilicon, 52: emitter electrode, 54: contact hole, 56: contact hole, 60: mesa portion, 62: wide mesa portion, 70: transistor portion, 90: edge termination structure portion, 92: guard ring, 100: semiconductor device, 130: gate runner, 160: active portion, 162: end side, 164: gate pad, 170: central portion, 180: outer circumferential portion, 182: first bottom region, 184: second bottom region, 192: first region, 194: second region, 200: semiconductor device, 202: region, 204: region, 206: sacrificial oxide film, 208: resist, 210: implantation region, 300: semiconductor device, 400: semiconductor device, 500: semiconductor device, 600: semiconductor device.

## Claims

1. A semiconductor device (100) comprising a semiconductor substrate (10) provided with a drift region (18) of a first conductivity type, wherein
the semiconductor substrate (10) includes:
an active portion (160), which is a region where a main current flows between an upper surface (21) and a lower surface (23) of the semiconductor substrate (10) when the semiconductor device (100) operates; and
a plurality of trench portions provided in the active portion (160) at the upper surface (21) of the semiconductor substrate (10),
the active portion (160) includes:
a first region (192) in which trench portions are arrayed at a first trench interval (L1) in an array direction; and
a second region (194) in which trench portions are arrayed at a second trench interval (L2) greater than the first trench interval (L1) in the array direction,
the first region (192) includes a first bottom region (182, 182-1, 182-2) of a second conductivity type provided over bottoms of at least two trench portions of the trench portions,
the second region (194) includes a second bottom region (184) of the second conductivity type provided at a bottom of one trench portion of the trench portions,
the semiconductor substrate (10) further includes an outer circumferential well region (11) of the second conductivity type which encloses the active portion (160) in a top view,
at least part of the second region (194) is sandwiched between two first regions (192) including the first region (192) in the array direction, and
the first bottom region (182-2) provided in one first region (192) of the two first regions (192) is electrically connected to the outer circumferential well region (11), and a boundary exists between said first bottom region (182-2) provided in said one first region and the outer circumferential well region (11).

2. The semiconductor device (100) according to claim 1, wherein
the second trench interval (L2) is twice or greater and four times or smaller than the first trench interval (L1).

3. The semiconductor device (100) according to claim 1 or 2, wherein
the second region (194) includes a gate trench portion (40) which is one of the trench portions, and
the second bottom region (184) is provided at a bottom of the gate trench portion (40).

4. The semiconductor device (100) according to any one of claims 1 to 3, wherein
the second region (194) includes at least two trench portions of the trench portions,
the second bottom region (184) is provided at a bottom of each of the two trench portions, and
the second bottom region (184) is not provided at a center of a mesa portion sandwiched between the two trench portions.

5. The semiconductor device (100) according to claim 4, wherein a part of the drift region (18) is provided between two second bottom regions (184) including the second bottom regions (184) which are adjacent to each other in the array direction.

6. The semiconductor device (100) according to claim 4, wherein
the semiconductor substrate (10) further includes an accumulation region (16) of the first conductivity type, and
a part of the accumulation region (16) is provided between two second bottom regions (184) including the second bottom regions (184) which are adjacent to each other in the array direction.

7. The semiconductor device (100) according to any one of claims 1 to 5, wherein
the semiconductor substrate (10) further includes an accumulation region (16) of the first conductivity type, and
a doping concentration of the accumulation region (16) provided in the second region (194) is lower than a doping concentration of the accumulation region (16) provided in the first region (192).

8. The semiconductor device (100) according to claim 6 or 7, wherein
an upper end of the second bottom region (184) and a lower end of the accumulation region (16) are in contact with each other in a depth direction of the semiconductor substrate (10).

9. The semiconductor device (100) according to any one of claims 1 to 8, wherein
the second trench interval (L2) is greater than 1.6 times a length of the second bottom region (184) in the array direction.

10. The semiconductor device (100) according to any one of claims 1 to 9, further including
an interlayer dielectric film (38) provided above the semiconductor substrate (10) and including contact holes (54-1, 54-2), wherein
an opening width of a contact hole (54-2) provided above the second region (194) is greater than an opening width of a contact hole (54-1) provided above the first region (192).

## Patentansprüche

1. Halbleiterbauelement (100), umfassend ein Halbleitersubstrat (10), das mit einer Driftregion (18) eines ersten Leitungstyps versehen ist, wobei
das Halbleitersubstrat (10) aufweist:
einen aktiven Bereich (160), der eine Region darstellt, in der bei Betrieb des Halbleiterbauelements (100) ein Hauptstrom zwischen einer Oberseite (21) und einer Unterseite (23) des Halbleitersubstrats (10) fließt; und
eine Mehrzahl von Grabenbereichen, die in dem aktiven Bereich (160) an der Oberseite (21) des Halbleitersubstrats (10) vorgesehen sind,
wobei der aktive Bereich (160) aufweist:
eine erste Region (192), in der Grabenbereiche in einer Anordnungsrichtung mit einem ersten Grabenabstand (L1) angeordnet sind; und
eine zweite Region (194), in der Grabenbereiche in der Anordnungsrichtung mit einem zweiten Grabenabstand (L2) angeordnet sind, der größer ist als der erste Grabenabstand (L1),
wobei die erste Region (192) eine erste Bodenregion (182, 182-1, 182-2) eines zweiten Leitungstyps aufweist, die über Böden von mindestens zwei Grabenbereichen der Grabenbereiche vorgesehen ist,
wobei die zweite Region (194) eine zweite Bodenregion (184) des zweiten Leitungstyps aufweist, die an einem Boden eines Grabenbereichs der Grabenbereiche vorgesehen ist,
wobei das Halbleitersubstrat (10) ferner eine äußere umlaufende Wannenregion (11) des zweiten Leitungstyps aufweist, die in einer Draufsicht den aktiven Bereich (160) umgibt,
wobei in der Anordnungsrichtung mindestens ein Teil der zweiten Region (194) zwischen zwei ersten Regionen (192), die die erste Region (192) beinhalten, angeordnet ist, und
wobei die erste Bodenregion (182-2), die in einer ersten Region (192) der zwei ersten Regionen (192) vorgesehen ist, elektrisch mit der äußeren umlaufenden Wannenregion (11) verbunden ist, und eine Grenze zwischen der in der ersten Region vorgesehenen ersten Bodenregion (182-2) und der äußeren umlaufenden Region (11) vorhanden ist.

2. Halbleiterbauelement (100) nach Anspruch 1, wobei
der zweite Grabenabstand (L2) mindestens doppelt so groß und höchstens viermal so groß ist wie der erste Grabenabstand (L1).

3. Halbleiterbauelement (100) nach Anspruch 1 oder 2,
wobei
die zweite Region (194) einen Gate-Grabenbereich (40) aufweist, der einer der Grabenbereiche ist, und
die zweite Bodenregion (184) an einem Boden des Gate-Grabenbereichs (40) vorgesehen ist.

4. Halbleiterbauelement (100) nach einem der Ansprüche 1 bis 3, wobei
die zweite Region (194) mindestens zwei Grabenbereiche der Grabenbereiche aufweist,
die zweite Bodenregion (184) jeweils an einem Boden eines jeden der zwei Grabenbereiche vorgesehen ist, und die zweite Bodenregion (184) nicht an einem Zentrum eines zwischen den beiden Grabenbereichen angeordneten Mesa-Bereichs vorgesehen ist.

5. Halbleiterbauelement (100) nach Anspruch 4, wobei
ein Teil der Driftregion (18) zwischen zwei zweiten Bodenregionen (184) vorgesehen ist, die die zweiten Bodenregionen (184) aufweisen, die in der Anordnungsrichtung benachbart zueinander angeordnet sind.

6. Halbleiterbauelement (100) nach Anspruch 4, wobei
das Halbleitersubstrat (10) ferner eine Akkumulationsregion (16) des ersten Leitungstyps aufweist, und
ein Teil der Akkumulationsregion (16) zwischen zwei zweiten Bodenregionen (184) vorgesehen ist, die die zweiten Bodenregionen (184) aufweisen, die in der Anordnungsrichtung benachbart zueinander angeordnet sind.

7. Halbleiterbauelement (100) nach einem der Ansprüche 1 bis 5, wobei
das Halbleitersubstrat (10) ferner eine Akkumulationsregion (16) des ersten Leitungstyps aufweist, und
eine Dotierkonzentration der Akkumulationsregion (16), die in der zweiten Region (194) vorgesehen ist, geringer ist als eine Dotierkonzentration der Akkumulationsregion (16), die in der ersten Region (192) vorgesehen ist.

8. Halbleiterbauelement (100) nach Anspruch 6 oder 7, wobei
ein oberes Ende der zweiten Bodenregion (184) und ein unteres Ende der Akkumulationsregion (16) in einer Tiefenrichtung des Halbleitersubstrats (10) miteinander in Kontakt stehen.

9. Halbleiterbauelement (100) nach einem der Ansprüche 1 bis 8, wobei
der zweite Grabenabstand (L2) in der Anordnungsrichtung größer ist als das 1,6-Fache einer Länge der zweiten Bodenregion (184).

10. Halbleiterbauelement (100) nach einem der Ansprüche 1 bis 9, ferner aufweisend
einen Zwischenschicht-Isolierfilm (38), der oberhalb des Halbleitersubstrats (10) vorgesehen ist und Kontaktlöcher (54-1, 54-2) aufweist, wobei
eine Öffnungsbreite eines Kontaktlochs (54-2), das oberhalb der zweiten Region (194) vorgesehen ist, größer ist als eine Öffnungsbreite eines Kontaktlochs (54-1), das oberhalb der ersten Region (192) vorgesehen ist.

## Revendications

1. Dispositif semi-conducteur (100) comprenant un substrat semi-conducteur (10) doté d'une zone de dérive (18) d'un premier type de conductivité, dans lequel
le substrat semi-conducteur (10) comprend :
une partie active (160), qui est une zone où circule un courant principal entre une surface supérieure (21) et une surface inférieure (23) du substrat semi-conducteur (10) lorsque le dispositif semi-conducteur (100) fonctionne ; et
une pluralité de parties de tranchées disposées dans la partie active (160) au niveau de la surface supérieure (21) du substrat semi-conducteur (10),
la partie active (160) comprend :
une première zone (192) dans laquelle des parties de tranchées sont disposées selon un premier intervalle de tranchée (L1) dans une direction de réseau ; et
une deuxième région (194) dans laquelle des parties de tranchées sont disposées selon un deuxième intervalle de tranchée (L2) supérieur au premier intervalle de tranchée (L1) dans la direction de réseau,
la première région (192) comprend une première région inférieure (182, 182-1, 182-2) d'un deuxième type de conductivité disposée sur des fonds d'au moins deux parties de tranchée des parties de tranchée,
la deuxième région (194) comprend une deuxième région inférieure (184) du deuxième type de conductivité disposée au fond d'une partie de tranchée des parties de tranchée,
le substrat semi-conducteur (10) comprend en outre une région de puits circonférentielle externe (11) du deuxième type de conductivité qui entoure la partie active (160) en vue de dessus,
au moins une partie de la deuxième région (194) est intercalée entre deux premières régions (192) y compris la première région (192) dans la direction de réseau, et
la première région inférieure (182-2) prévue dans une première région (192) des deux premières régions (192) est connectée électriquement à la région de puits circonférentielle externe (11), et une limite existe entre ladite première région inférieure (182-2) prévue dans une dite première région et la région de puits circonférentielle externe (11).

2. Dispositif semi-conducteur (100) selon la revendication 1, dans lequel
le deuxième intervalle de tranchée (L2) est deux fois ou plus grand et quatre fois ou plus petit que le premier intervalle de tranchée (L1).

3. Dispositif semi-conducteur (100) selon la revendication 1 ou 2, dans lequel
la deuxième région (194) comprend une partie de tranchée de grille (40) qui est une des parties de tranchée et la deuxième région inférieure (184) est disposée au fond de la partie de tranchée de grille (40).

4. Dispositif semi-conducteur (100) selon une quelconque des revendications 1 à 3, dans lequel
la deuxième région (194) comprend au moins deux parties de tranchée des parties de tranchée,
la deuxième région inférieure (184) est disposée au fond de chacune des deux parties de tranchées, et
la deuxième région inférieure (184) n'est pas disposée au centre d'une partie de mesa intercalée entre les deux tranchées.

5. Dispositif semi-conducteur (100) selon la revendication 4, dans lequel une partie de la région de dérive (18) est disposée entre deux deuxièmes régions inférieures (184), comprenant les deuxièmes régions inférieures (184) adjacentes l'une à l'autre dans la direction de réseau.

6. Dispositif semi-conducteur (100) selon la revendication 4, dans lequel
le substrat semi-conducteur (10) comprend en outre une zone d'accumulation (16) du premier type de conductivité et
une partie de la zone d'accumulation (16) est disposée entre deux deuxièmes zones inférieures (184), adjacentes dans la direction de réseau.

7. Dispositif semi-conducteur (100) selon une quelconque des revendications 1 à 5, dans lequel
le substrat semi-conducteur (10) comprend en outre une zone d'accumulation (16) du premier type de conductivité, et
une concentration de dopage de la zone d'accumulation (16) dans la deuxième zone (194) est inférieure à une concentration de dopage dans la région d'accumulation (16) dans la première zone (192).

8. Dispositif semi-conducteur (100) selon la revendication 6 ou 7, dans lequel
une extrémité supérieure de la deuxième région inférieure (184) et une extrémité inférieure de la région d'accumulation (16) sont en contact l'une avec l'autre dans une direction de profondeur du substrat semi-conducteur (10).

9. Dispositif semi-conducteur (100) selon une quelconque des revendications 1 à 8, dans lequel
le deuxième intervalle de tranchée (L2) est supérieur à 1,6 fois la longueur de la deuxième région inférieure (184) dans la direction de réseau.

10. Dispositif semi-conducteur (100) selon une quelconque des revendications 1 à 9, comprenant en outre
un film diélectrique intercalaire (38) disposé au-dessus du substrat semi-conducteur (10) et comprenant des trous de contact (54-1, 54-2), dans lequel
une largeur d'ouverture d'un trou de contact (54-2) disposé au-dessus de la deuxième région (194) est supérieure à une largeur d'ouverture d'un trou de contact (54-1) disposé au-dessus de la première région (192) .
